(19) **Europäisches Patentamt / European Patent Office / Office européen des brevets**

(11) **EP 1 042 782 B1**

(12) # EUROPÄISCHE PATENTSCHRIFT

(45) Veröffentlichungstag und Bekanntmachung des Hinweises auf die Patenterteilung:
**15.10.2008 Patentblatt 2008/42**

(21) Anmeldenummer: **98958771.2**

(22) Anmeldetag: **22.12.1998**

(51) Int Cl.:
*H01J 37/32* *(2006.01)*

(86) Internationale Anmeldenummer:
**PCT/CH1998/000548**

(87) Internationale Veröffentlichungsnummer:
**WO 1999/034398 (08.07.1999 Gazette 1999/27)**

(54) **VAKUUMBEHANDLUNGSANLAGE**

VACUUM TREATMENT SYSTEM

INSTALLATION DE TRAITEMENT SOUS VIDE

(84) Benannte Vertragsstaaten:
**AT BE CH DE ES FI FR GB IE IT LI NL PT SE**

(30) Priorität: **23.12.1997 CH 295897**

(43) Veröffentlichungstag der Anmeldung:
**11.10.2000 Patentblatt 2000/41**

(73) Patentinhaber: **OC Oerlikon Balzers AG**
**9496 Balzers (LI)**

(72) Erfinder: **MULLIS, Felix**
**CH-8890 Flums (CH)**

(74) Vertreter: **Troesch Scheidegger Werner AG**
**Patentanwälte**
**Postfach**
**8032 Zürich (CH)**

(56) Entgegenhaltungen:
EP-A- 0 467 391        WO-A1-98/11412
DE-A- 4 203 672        US-A- 5 365 147

- **LAIMER J.: 'Plasmaunterstützte Abscheidung aus der Gasphase zur Erzeugung dünner harter Titannitrid-Schichten.', 20 Januar 1989, DISSERTATION TECHNISCHE UNIVERSITCT WIEN 1987**
- **KONUMA M.: 'Film Deposition by Plasma Techniques', 1992, SPRINGER VERLAG**

**Beschreibung**

Die vorliegende Erfindung betrifft eine Vakuumbehandlungsanlage mit mindestens einer Vakuumbehandlungskammer, wobei ein erster Teil der Anlage mit einem elektrischen Anlage-Bezugspotential - üblicherweise Massepotential - verbunden ist, in der Vakuumkammer ein weiterer Teil vorgesehen ist, der auf ein vom Anlage-Bezugspotential um mindestens $\pm$ 12 V abweichendes elektrisches Potential gelegt ist und wobei an diesem weiteren Teil mindestens ein Sensor und/oder mindestens ein Stellglied angeordnet ist, weiter mit einer Elektronikeinheit, welche ein- und/oder ausgangsseitig mit dem Sensor und/oder Stellglied wirkverbunden ist.

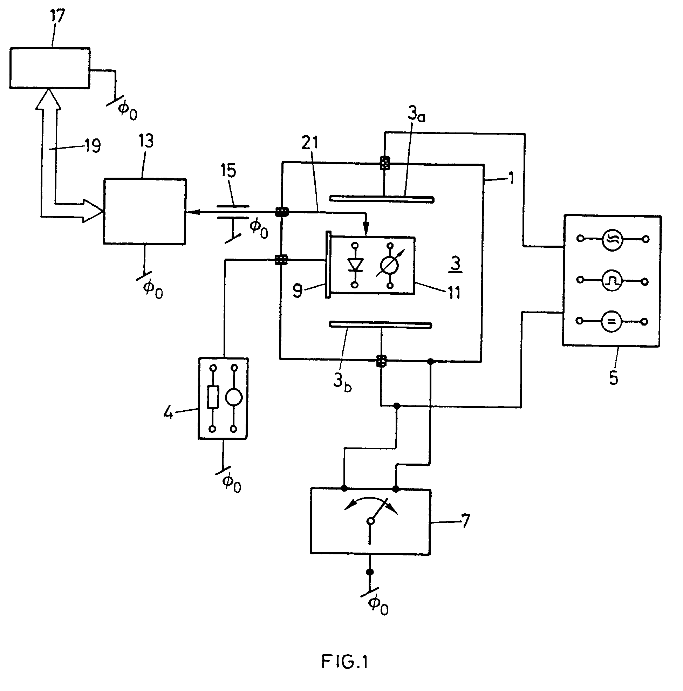

In Fig. 1 ist eine solche, vorbekannte Vakuumbehandlungsanlage, als Beispiel mit einer Plasma-Entladungsstrecke, schematisch dargestellt und soll anhand dieser Figur diskutiert werden. In der Vakuumkammer 1 ist bei diesem Beispiel eine Plasmaentladungsstrecke vorgesehen zwischen Elektroden $3_a$ und $3_b$. Die mit 3 bezeichnete Entladungsstrecke wird durch eine Speiseeinheit 5 elektrisch betrieben, sei dies mit DC, mit gepulstem DC, mit AC oder mit AC und überlagertem DC, wobei die AC-Signalfrequenz im Hz- bis im Hochfrequenz- bzw. gar im Mikrowellenbereich liegen kann.

Zum Zwecke der Erläuterung sind in Fig. 1 die elektrischen Zuführungen zur Entladestrecke 3 von der Kammer 1 elektrisch isoliert dargestellt. Es bestehen verschiedene Möglichkeiten, das Anlagen-Referenzpotential, üblicherweise Massepotential, $\phi_o$, aufzuschalten. Dies ist schematisch mit den Möglichkeiten-Wahlschalter 7 dargestellt. Üblich ist z.B., das Gehäuse 1 sowie eine der Elektroden $3_a$, $3_b$ auf Masse zu legen. In der Vakuumkammer 1 ist ein weiterer Teil 9 dargestellt, beispielsweise ein Substratträger, ein Instrumententräger, eine weitere Elektrode etc., wobei dieser, aus Gründen der Erläuterungen separat gezeichnete Teil 9 auch eine der Elektroden $3_a$, $3_b$ sein kann. Dieser Teil 9 liegt nun nicht auf Potential $\phi_0$. Dies ist dargestellt mit der Einheit 4, entsprechend einem Impedanz- und/oder Quellen-Ersatzbild.

Die vorliegende Erfindung geht von Problemen aus im Zusammenhang mit Teil 9 in der Kammer 1, der nicht auf das Anlagen-Bezugspotential $\phi_o$ gelegt ist. Er liegt auf sonst beliebigem, von $\phi_o$ massgeblich, d.h. um mindestens $\pm$ 12 V abweichendem, elektrischem Potential $\phi_9$, d.h. auf DC-Potential, auf AC-Potential, auf überlagertem AC- und DC-Potential, auf einem gepulsten DC-Potential, wobei frequenzmässig das AC-Potential bis in den Hochfrequenzbereich angesiedelt sein kann oder gar in den Mikrowellenbereich. Ist beispielsweise der Teil 9 ein Substratträger, so kann dieser, bei elektrisch isolierter Montage, bezüglich $\phi_o$ auf Self-bias-Potential der Entladung betrieben sein. Ist der Teil 9 eine der Elektroden $3_a$, $3_b$ bei Hf-Plasmaerzeugung, so liegt er bezüglich $\phi_o$ auf hohem Hf-Potential.

Wie nun weiter in Fig. 1 dargestellt ist, ist es häufig notwendig, am erwähnten, nicht auf Anlagen-Bezugspotential $\phi_o$ betriebenen Teil 9, wie schematisch an der Einheit 11 dargestellt, mittels mindestens einem Sensor und/oder mindestens einem Stellglied, Messungen bzw. Stelleingriffe vorzunehmen. Stellsignale bzw. Sensorausgangssignale werden von einer Elektronik-Einheit 13 an die Einheit 11 übermittelt bzw. von letzterer erhalten. Es ist üblich, wie in Fig. 1 dargestellt, eine solche Elektronik-Einheit 13 auf das Anlagen-Bezugspotential $\phi_o$ zu legen. Eine solche Elektronik-Einheit ist oft

- eine digitale, programmierbare Einheit, mit Speichermitteln für die Betriebsprogramme, dabei vorzugsweise umfassend

- mindestens einen programmierbaren, digitalen Logikbaustein und/oder

- eine digitale Rechnereinheit,

- vorzugsweise umfasst sie mindestens einen Mikroprozessor und/oder einen Mikrocomputer, mit zugeordneten Speichermitteln für Betriebsprogramme.

Der Grund für die Bezugspotential-Legung liegt darin, dass, z.B. bei Hf-Betrieb der Entladungsstrecke, einfache Schutzmassnahmen möglich sind, wie schematisch bei 15 dargestellt ist, z.B. mittels ebenfalls auf $\phi_o$ gelegter Abschirmungen. Im weiteren ist die signalmässige Kommunikation zwischen Einheit 13 und einer dieser übergeordneten Einheit 17, wie beispielsweise einem übergeordneten Rechner, besonders einfach. Die Kommunikations-Schnittstelle 19 weist, als Bezugspotential, das Anlage-Bezugspotential $\phi_o$ auf, das wie erwähnt üblicherweise Massepotential ist. Subsumiert man unter die Kommunikations-Verbindung zwischen Einheit 11 und Einheit 13, welche in Fig. 1 mit 21 schematisiert ist, auch ggf. Speisesignale für die Einheit 11 von einem externen Speisegerät, so werden die zugeführten Spannungen an die Einheit 11, durch geeignete elektronische Mittel, auf den Mess- bzw. Stellbereich von üblicherweise einigen wenigen Volt reduziert, wozu z.B. Spannungsteiler, wie in der US 5 270 637 beschrieben, und/oder geeignete Gleichrichter und Filterelemente, wie in der US 5 144 231 gezeigt, eingesetzt werden.

Es ergeben sich bei dieser vorbekannten Anordnung Probleme:

- Mess- und Stellsignale von bzw. an die Einheit 11 müssen von oft grossen "Common Mode"-Signalen getrennt werden, nämlich vom erwähnten, zwischen Teil 9, $\phi_9$ und $\phi_o$ liegenden Signal, was insbesondere dann aufwendig ist, wenn die Partie 9 auf Hf-Potential, insbesondere hohem Hf-Potential, liegt oder auf Potential mit hohen, höherfrequenten Spektralanteilen, wie sie bei Inpulsbetrieben, Störfunkenbildung, Einschaltvorgängen etc. auftreten. Aber auch dann, wenn der Teil 9 auf idealem DC-Potential bezüglich $\phi_o$ liegen würde, bleibt das Problem bestehen, dass an der Einheit 11 relativ kleine Mess- bzw. Stellsignale bezüglich eines grossen "Common Mode"-Signals verarbeitet werden müssen, was die Genauigkeit bzw. Auflösung der erwähnten Mess- bzw. Stellsignale stark einschränkt. Wenn der Teil 9 beispielsweise auf Hf-Potential betrieben wird, muss für jede einzelne Mess- bzw. Steuerleitung von bzw. zur Einheit 11 ein Hf-Filter vorgesehen werden - mit, je nach Aufwand, beschränkter Wirkung - ebenso für jedes zusätzliche Signal, wie z.B. für Speisesignale an die Einheit 11, um bezüglich der Elektronikeinheit 13 eine optimale Hf-Entkopplung sicherzustellen. Dies ist mit einem erheblichen Aufwand verbunden. Zudem müssen insbesondere Mess- und Steuersignalleitungen zur Einheit 11 effizient abgeschirmt werden, insbesondere, wenn man die üblicherweise hochohmigen und empfindlichen Eingänge der Einheit 13 berücksichtigt. Grundsätzlich müssen aufwendige Vorkehrungen zum Schutz der Elektronik vorgesehen werden.

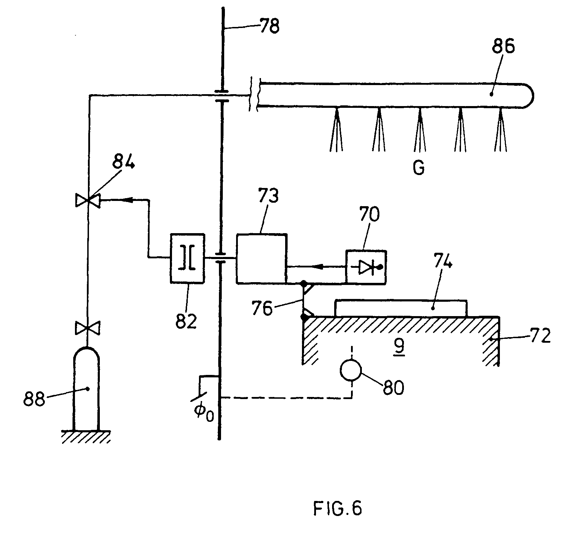

Die Dissertation von J. Laimer, "Plasmaunterstützte Abscheidung aus der Gasphase zur Erzeugung dünner harter Titannitrid-Schichten", Technische Universität Wien 1987 (veröffentlicht 20.1.1989) offenbart eine PACVD-Anlage, die mit Hochfrequenz (13,56 MHz) betrieben wird. In die Hochfrequenzelektroden sowie in den Substrathalter sind Thermoelemente integriert, deren Thermospannungen durch jeweils eigene, floatende, Spannungs-Frequenzwandler mit Hilfe von Optokopplern in Lichtsignale umgewandelt und über Lichtleiter zu einer Wandler-Anzeigeeinheit außerhalb der Vakuumkammer übertragen werden (siehe insbesondere Kapitel 6.6 auf Seite 110 und Abb. 6.13). Die Spannungs-Frequenzwandler und Optokoppler sowie deren Spannungsversorgung, die zur Vermeidung einer Auskopplung der Hochfrequenz mit Netzfiltern bestückt ist, sind in einer Filterbox angeordnet, ebenfalls außerhalb der Vakuumkammer.

Weiter ist aus der US 5365147 A eine Dreileiter-Plasmasonde zur Messung von Elektronendichte und Elektronentemperatur bekannt, deren Auswerteelektronik Koppelelemente in Form von z.B. Trennverstärkern oder Photo-Isolatoren umfasst. Auch hier ist die Auswerteelektronik außerhalb der Plasmakammer (1) angeordnet.

Demgegenüber ist es Aufgabe der Erfindung, eine Erhöhung der Mess- bzw. Stellgenauigkeit zu realisieren, wobei eine Herausführung entsprechender Signale aus der Vakuumkammer wesentlich unproblematischer ist.

Dies wird durch eine Vakuumbehandlungsanlage gelöst, wie sie in Anspruch 1 definiert ist. Erfindungsgemäß ist eine mit einem Sensor und/oder Stellglied verbundene Elektronik-Einheit innerhalb der Vakuumbehandlungskammer eingebaut.

Gegenüber der Vakuumbehandlungsanlage der anhand von Fig.1 diskutierten Art ergibt sich eine wesentliche Vereinfachung der Signalverarbeitung mit der Elektronikeinheit 13, eine genauere Messignalauswertung bzw. eine genauere Stellglied-Variation, und eine wesentlich kostengünstigere Vakuumbehandlungsanlage dadurch, dass die Elektronikeinheit, wie in Anspruch 1 definiert und abweichend von der anhand von Fig. 1 beschriebenen, vorbekannten Technik, auf einem weiteren Bezugspotential betrieben ist, welches weitere Bezugspotential gleich dem Potential des weiteren Teils 9 ist.

Diese Potentiallegung ist insbesondere dort mit wenig Aufwand höchst wirkungsvoll, wo der Betrieb der Vakuumbehandlungsanlage zum Auftreten teilweise stochastischer, hochfrequenter Signalanteile führt. Eine Vakuumbehandlungsanlage, bei welcher solcher Vorgänge häufig auftreten, ist insbesondere eine Anlage, bei der eine Entladungsstrecke eingesetzt wird.

Bei der erfindungsgemässen Anlage bildet der erwähnte weitere Teil 9 vorzugsweise eine der Entladungselektroden, oder ist ein der Entladung ausgesetzter Teil, der auf Schwebepotential betrieben wird und mithin beispielsweise Self-bias-Potential der Entladung einnimmt oder der auf bestimmtem Potential betrieben wird.

In einer weiteren bevorzugten Ausführungsform, dabei insbesondere bei der erwähnten Anlage mit Entladungsstrecke, ist der erwähnte mindestens eine Sensor ein Temperatursensor, das Stellglied ist eine Heiz- und/oder Kühleinrichtung, dabei vorzugsweise eine Mehrzonenheizung bzw. -kühlung, wobei weiter bevorzugterweise in diesem Fall der weitere Teil 9 durch einen Werkstückträger gebildet ist. Dabei kann eine Temperatursteuerung realisiert sein oder, und in bevorzugter Art und Weise, eine Temperaturregelung. Der Sensor oder eine Mehrzahl vorgesehener Sensoren nimmt die Regelgrösse Temperatur bzw. Temperaturverteilung auf. An der Elektronik-Einheit, auf Potential des Teils 9, wird das Regelgrössen-Messignal verstärkt und ausgangsseitig auf höherem, Störgrössen-unempfindlicherem Pegel einer übergeordneten Einheit zugeführt, woran SOLL/IST-Wert-Vergleich vorgenommen wird und woran gegebenenfalls auch der Regler mit erwünschter Charakteristik realisiert ist. Das rückgeführte Signal wird von der übergeordneten Einheit der erwähnten Elektronik-Einheit am Teil 9 zugespiesen, welche das Temperatur- bzw. Temperaturverteilungs-Stellersignal an das oder die Temperaturstellglied(er) abgibt. Andernfalls, und bevorzugt, bildet die Elektronikeinheit direkt den SOLL/IST-WertVergleich und die erwünschte Reglercharakteristik.

Bei diesem Vorgehen werden Temperaturgenauigkeiten von mindestens $\pm$ 5°C bei Stellbereichen von einigen 100°C Full-Scale ohne weiteres erreichbar, vorzugsweise von mindestens $\pm$ 2°C bzw. gar von mindestens $\pm$ 1°C.

Derartige Temperatur-Steuer- bzw. - Führungsgenauigkeiten stellten bei bekanntem Vorgehen nach Fig. 1 grosse Probleme.

Eine solche Temperaturführung ist insbesondere dann höchst wünschenswert, wenn der erwähnte Teil 9 ein Werkstückträger in der Anlage ist oder wenn der Teil 9 eine Targetanordnung der Anlage ist.

In einer weiteren bevorzugten Ausführungsform bildet der erwähnte Teil 9 eine Werkstückaufnahme. Der Sensor überprüft Vorhandensein oder Nichtvorhandensein eines Werkstückes an der Aufnahme. Umfasst die Werkstückaufnahme, welche den erwähnten Teil 9 bildet, elektrostatisch oder durch Unterdruck auf ein Werkstück wirkende Halteorgane, so wird weiter bevorzugterweise der vorerwähnte oder ein weiterer Sensor vorgesehen zur Überprüfung der Werkstückhalterung, und es wird bevorzugterweise vom Sensor über die Elektronik-Einheit auf die erwähnte Halterung rückgewirkt.

Damit ist es möglich, die Haftbedingung bzw. die Halterung der Werkstücke in der Kammer zu überprüfen und ggf. nachzustellen bzw. nachzuregeln.

Bei einer weiteren bevorzugten Ausführungsform der erfindungsgemässen Anlage wird der erwähnte weitere Teil 9 unmittelbar im Bereich eines Gaseinlasses in die Vakuumkammer vorgesehen und der Sensor als Gasflussfühler ausgebildet. Die Elektronikeinheit wirkt ausgangsseitig auf eine Stellventilanordnung in einer Gasführung zum Gaseinlassen.

Alternativ wird beim letzterwähnten Vorgehen der erwähnte Teil 9 unmittelbar im Bereich eines Werkstückes vorgesehen. Jedenfalls ist es auf diese Art möglich, eine präzise Gaseinlass-Steuerung oder -Regelung direkt am Ort des massgeblichen Geschehens vorzunehmen, was ein verzugsloses, schnelles und präzises Reagieren auf von Sollbetriebszuständen abweichende Istbetriebszustände ermöglicht.

Wie bereits angedeutet, wird an einer weiteren bevorzugten Ausführungsform der weitere Teil 9 an einer Targetanordnung vorgesehen, wo der Sensor die Temperatur des Target und/oder seinen Zustand misst bzw. erfasst. Durch das erfindungsgemässe Vorgehen ist es möglich, trotz schwierigen elektrischen Verhältnissen in Targetumgebung (durch Transiente, beispielsweise ausgelöst durch Störfunken) mit hoher Genauigkeit Targettemperatur oder generell Targetzustand, wie beispielsweise sein Erosionsmass zu erfassen und über die Elektronik-Einheit Steuer- oder Regeleingriffe vorzunehmen.

Die erwähnte Elektronik-Einheit, auf dem Potential des Teiles 9 betrieben, wird erfindungsgemäss innerhalb der Vakuumkammer vorgesehen ; mindestens ihre Eingangsstufe für den Sensor bzw. Ausgangsstufe für das Stellglied werden unmittelbar im Bereich der erwähnten Sensoren bzw. Stellglieder und mithin in der Vakuumkammer angeordnet.

In einer weiteren bevorzugten Ausführungsform der erfindungsgemässen Anlage ist der weitere Teil 9 bezüglich dem Anlagen-Bezugspotential auf AC- und/oder DC-Potential gelegt, oder ist vom Anlagen-Bezugspotential elektrisch isoliert angeordnet. AC umfasst dabei insbesondere den Hf-Bereich, kann sich aber bis in den Mikrowellenbereich erstrecken. Bevorzugterweise ist der weitere Teil ein Substrat- bzw. Werkstückträger. Insbesondere dort ist das Vorsehen von Sensoren und/oder Stellgliedern, wie beispielsweise für die Temperatur-Stellung oder -Regelung, wie erwähnt, oft erwünscht.

Liegt der weitere Teil bezüglich Anlagen-Bezugspotential auf Hf-Potential, auch z.B. für Bias-Betrieb gegenüber einem Plasma, so bevorzugterweise in einem Frequenzbereich von 100 kHz bis 100 MHz, dabei vorzugsweise zwischen 5 MHz und 50 MHz, insbesondere bevorzugterweise auf der Industriefrequenz von ca. 13,56 MHz. Weiter liegt bevorzugterweise die Potentialdifferenz $\phi_0 - \phi_9$ wie folgt:

$$12 \text{ V} \leq |\phi_0 - \phi_9| \leq 2000 \text{ V},$$

bevorzugt

$$25 \text{ V} \leq |\phi_0 - \phi_9| \leq 500 \text{ V}.$$

Spitzen-Spitzen-Spannung $V_{pp}$ am erwähnten Teil 9 und bezüglich Anlagen-Bezugspotential bei AC, insbesondere Hf-Betrieb, liegen vorzugsweise im Bereich

$$25 \text{ V} \leq V_{pp} \leq 2'000 \text{ V},$$

dabei bevorzugterweise:

$$50 \text{ V} \leq V_{pp} \leq 500 \text{ V}.$$

In weiter bevorzugter Ausführungsform umfasst die erwähnte Elektronikeinheit mindestens eine digitale, vorzugsweise programmierbare Einheit, vorzugsweise mindestens einen programmierbaren, digitalen Logikbaustein und/oder mindestens eine digitale Rechnereinheit, vorzugsweise mindestens einen Mikroprozessor und/oder Mikrocomputer. Vorzugsweise sind an der Elektronikeinheit, falls erforderlich, Speichermittel für Betriebsprogramme vorgesehen.

Die Elektronik-Einheit ist, weiter bevorzugterweise, direkt mechanisch am erwähnten weiteren Teil 9 angeordnet. Insbesondere bei auf Hf-Potential liegendem weiteren Teil 9 wird vorzugsweise die erwähnte Elektronikeinheit von einem Faradaykäfig umschlossen, welcher vorzugsweise auf das Potential des Teils 9 gelegt ist. Im weiteren wird bevorzugterweise vorgeschlagen, dass Verbindung von und/oder zu der Elektronik-Einheit mindestens teilweise über galvanischen Trennstellen geführt sind und/oder über Hf-Filteranordnungen. Solche Filteranordnungen werden dabei vorzugsweise von einer auf dem Anlagen-Bezugspotential liegenden Faradaykäfig-Anordnung umschlossen.

In einer bevorzugten Ausführungsform kommuniziert die erwähnte Elektronikeinheit mit einer übergeordneten Stell- und/oder Überwachungseinheit, z.B. einem Host-Rechner, welche ausserhalb der Vakuumkammer angeordnet ist. Signalverbindungen zwischen der Elektronikeinheit und der übergeordneten Einheit erfolgen vorzugsweise über eine galvanische Trennstelle, wie über transformatorische Übertrager, vorzugsweise über Lichtleiter.

Die Erfindung wird anschliessend beispielsweise anhand von Figuren erläutert. In den Figuren zeigen:

Fig. 1:     schematisch die interessierenden elektrischen Verhältnisse an vorbekannten Vakuumbehandlungsanlagen,

Fig. 2:     in einer schematischen Darstellung, analog zu Fig. 1, eine erfindungsgemässe Vakuumbehandlungsanlage,

Fig. 3:     schematisch eine bevorzugte Ausführungsform der als Substratträger ausgebildeten, weiteren Partie einer Hf-Plasma-Vakuumbehandlungsanlage,

Fig. 4:     schematisch eine erste erfindungsgemässe Temperaturverteilungsregelung,

Fig. 5:     eine zweite erfindungsgemässe Temperaturverteilungsregelung und

Fig. 6:     eine erfindungemässe Gasfluss-Steuerung oder -Regelung, schematisch dargestellt.

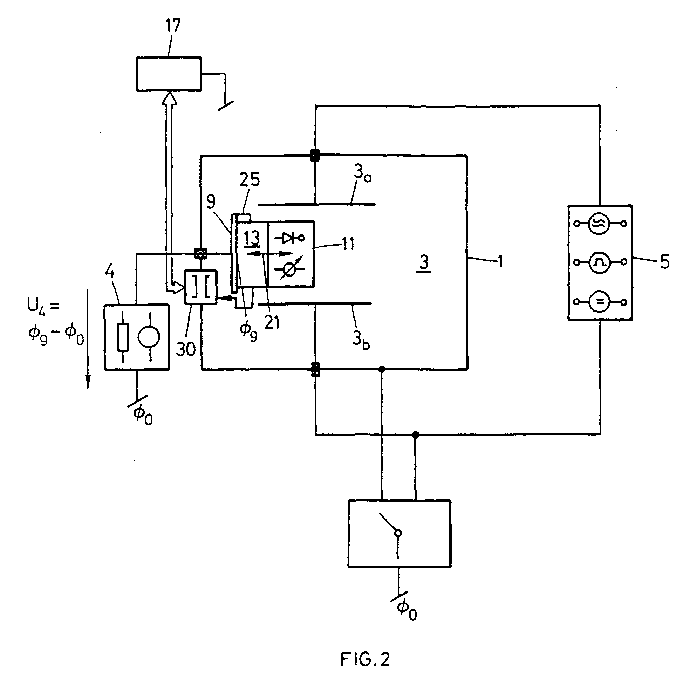

In Fig. 2 sind die bereits anhand von Fig. 1 erläuterten Teile gleich wie in Fig. 1 bezeichnet. Der Teil 9, bei dem es sich, wie anhand von Fig. 1 erläutert wurde, grundsätzlich um einen Teil handelt, der nicht auf Anlagepotential $\phi_0$ gelegt ist, also durchaus auch um eine der Elektroden $3_a$, $3_b$ handeln kann, liegt, wie mit der Einheit 4 schematisiert, über eine Impedanz-und/oder eine Signalquellen-Anordnung (Ersatznetzwahl) auf Anlage-Bezugspotential $\phi_0$ bezogen. Im Unterschied zur vorbekannten Anlage nach Fig. 1 ist, primär, als Bezugspotential der Elektronik-Einheit 13, wie mit der galvanischen Verbindung 25 dargestellt, das Potential $\phi_9$ dem Teil 9 aufgeschaltet. Die Elektronik-Einheit 13 ist innerhalb der Kammer 1 eingebaut; bevorzugterweise, aber nicht zwingend, ist dabei die Einheit 13 mechanisch bzw. baulich am Teil 9 angeordnet. Damit ergeben sich optimal kurze Verbindungen 21 zwischen Einheit 13 und Sensoren bzw. Stellgliedern 11, und insbesondere werden die daran übermittelten Signale durch die Potentialdifferenz bzw. durch die Spannung $U_4$ ($\phi_9$ minus $\phi_0$) nicht gestört. Damit wird eine wesentliche Erhöhung der Mess- bzw. Stellgenauigkeit realisiert, weil nicht mehr länger kleine Stell- bzw. Messignale, grossen "Common Mode"-Signalen überlagert, an der Einheit 13 verarbeitet werden müssen. So kann eine Signalaufbereitung störungsfrei an der Einheit 13 erfolgen, und es können leistungsschwache Signale daran auf derart hohe Pegel verstärkt werden, dass eine nachgelagerte Weiterführung, insbesondere Herausführung entsprechender Signale aus der Kammer 1 wesentlich unproblematischer ist. Die Verbindung mindestens eines Teils von Signalen zwischen Einheit 13 und einer Einheit ausserhalb der Vakuumkammer 1, wie beispielsweise an den übergeordneten Rechner 17, erfolgt über eine in Fig. 2 schematisch dargestellte galvanische Trenneinrichtung 30, wie beispielsweise über transformatorische Übertrager oder über Lichtleiter bzw. Optokoppler.

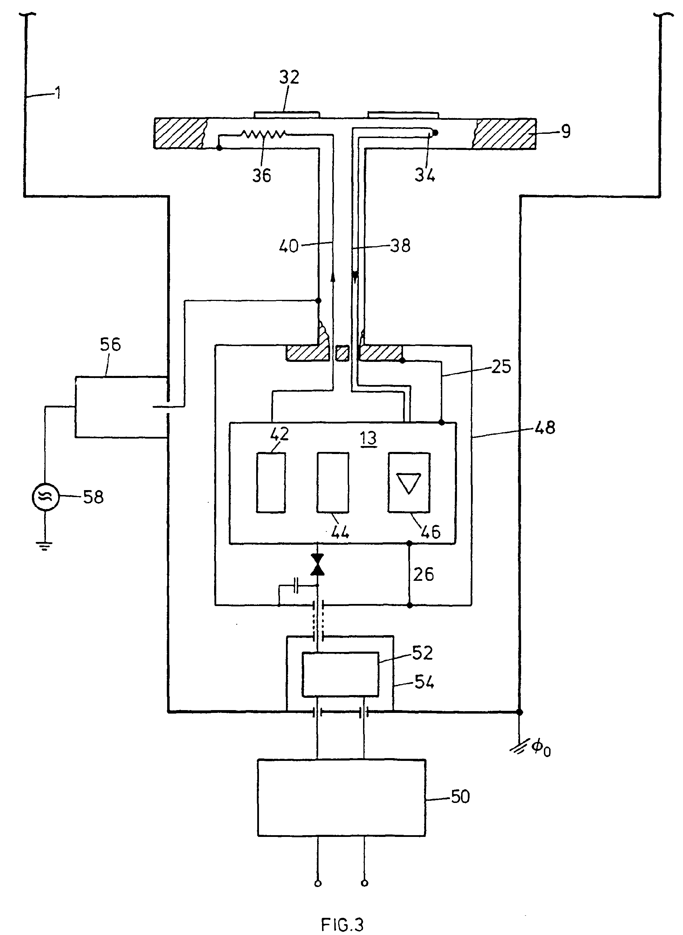

In Fig. 3 ist, detaillierter, ein Ausschnitt einer bevorzugten erfindungsgemässen Anlage dargestellt. Hier wird der Teil 9 als eine der in den Fig. 1 bzw. 2 dargestellten Entladungselektrode $3_a$, $3_b$ für eine Hf-Plasmaentladung eingesetzt. Gleichzeitig bildet dieser Teil 9 gemäss Fig. 3 Substratträger für in der Kammer 1 zu behandelnde Substrate 32. Teil 9 wird nun Substratträger 9 genannt. Als Sensor ist am Substratträger 9 ein Thermofühler 34 eingebaut, als Stellglied für die Temperatur eine Heizwiderstandsanordnung 36. Messignalleitung 38 von der Sensoranordnung 34 bzw. Stellsignalleitungen 40 zur Stellereinrichtung 36 sind auf die Elektronikeinheit 13 geführt, welche einen Mikroprozessor mit Speichereinheit für Betriebsprogramme umfasst. In der Einheit 13 sind nebst dem erwähnten Mikroprozessor beispielsweise angeordnet, eine Stellgliedsteuerungs-Endstufe 42, beispielsweise mit entsprechendem Digital/Analog-Wandler, eine Spannungsversorgungs-Einheit 44 für die Gesamteinheit 13, eine Messignalverstärker-Eingangsstufe 46 mit entsprechendem Analog/Digital-Wandler.

Die Einheit 13 ist, wie mit der galvanischen Verbindung 25 dargestellt, auf dem elektrischen Potential des Substratträgers 9 betrieben. Im weiteren ist bevorzugterweise die Einheit 13 von einem, wie mit der galvanischen Verbindung 26 dargestellt, auf dem Potential des Substratträgers 9 betriebenen Faradaykäfig 38 umgeben . Ausgangssignale von der Einheit 13, die aus der Kammer 1 geführt werden, die auf Anlagen-Bezugspotential $\phi_0$, d.h. Massepotential liegt, sowie Eingangssignale, welche von ausserhalb der Kammer 1 der Einheit 13 zugeführt werden, werden mindestens teilweise über eine galvanische Trenneinheit 50, wie erwähnt über transformatorische Übertrager und/oder über Lichtleiter bzw. Optokoppler, geführt. Bevorzugterweise ist zusätzlich eine Hf-Filteranordnung 52 zwischen galvanischer Trenneinheit 50 und Elektronikeinheit 13 vorgesehen. Die Filteranordnung 52 ist vorzugsweise in einem Faradaykäfig 54 angeordnet, welch letzterer auf Anlage-Bezugspotential $\phi_0$ betrieben ist. Entsprechend dem Betriebsfrequenzbereich sind Durchführungen durch die Faradaykäfige 48 bzw. 54 in ihrem Durchmesser beschränkt. Als eine der Hf-Plasma-Entladungselektroden, z.B. bei 13,56 MHz betrieben, ist der Substratträger 9 über eine Matchbox 56 mit dem Hf-Generator 58 für die Hf-Plasmaentladung verbunden.

Durchführungen, wie für elektrische Energie, ein Kühl- oder Heizmedium etc., durch den Faradaykäfig 48 weisen für den erwähnten Frequenzbereich Durchmesser von höchstens 5 cm, vorzugsweise von weniger als 1 cm, auf. Auch die Spannungsversorgung der Einheit 13 erfolgt vorzugsweise über eine galvanische Trennung an der Einheit 50 und über entsprechende Filter der Filteranordnung 52.

Wird mit der in Fig. 3 dargestellten Sensor/Steller-Anordnung die Anlage nach dem in Fig. 1 gezeigten bekannten Prinzip betrieben bzw. wie in Fig. 3 gezeigt, so ergeben sich bei erfindungsgemässer Anlagenkonstellation um einen Faktor von mindestens 10 höhere Genauigkeiten.

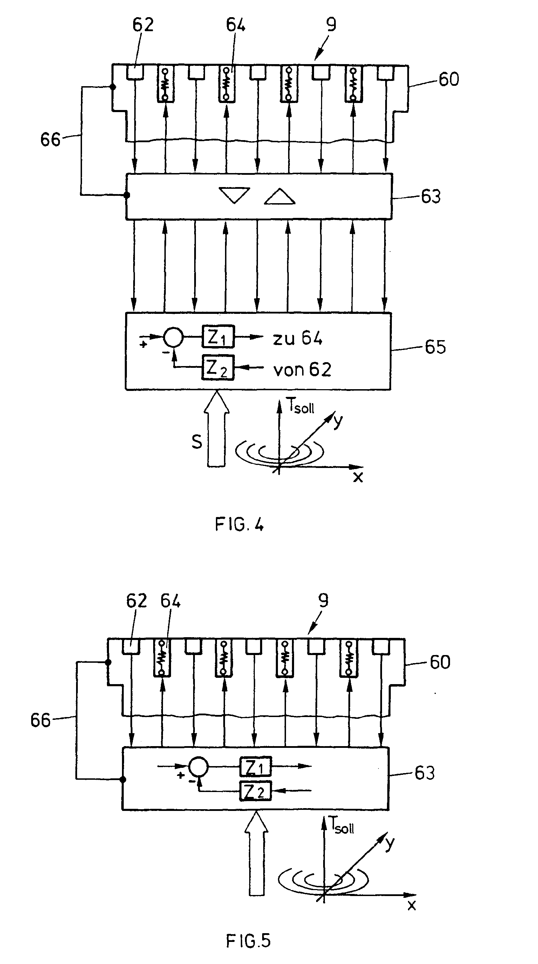

In Fig. 4 ist schematisch eine weitere bevorzugte Ausführungsform der erfindungsgemässen Anlage in Teilansicht dargestellt. An einem Werkstückträgertisch 60, beispielsweise einem Hubtisch, sind matrixartig eine Mehrzahl von Sensoren 62 bzw. von Heiz- und/oder Kühlelementen 64 angeordnet. Die Ausgangssignale der Sensoren 62 sind auf die Elektronik-Einheit 63 geführt. Die Elektronik-Einheit 63 ist dabei, wie mit der galvanischen Verbindung 66 dargestellt, auf das Potential des als Teil 9 wirkenden Werkstückaufnahmetisches 60 gelegt. In der Elektronik-Einheit 63 werden die Ausgangssignale der Sensoren 62 im Sinne einer drastischen Erhöhung des nachfolgenden Signal-zu-Rausch-Verhältnisses verstärkt und ausgangsseitig an eine der Einheit 63 nachgelagerte, vorzugsweise ausserhalb der Vakuumkammer angeordnete Elektronik-Einheit 65 übertragen. Umgekehrt sind die Ausgangssignale der übergeordneten Elektronik-Einheit 65 zurück auf die erfindungsgemäss potentialgelegte Elektronik-Einheit 63 geführt, welche sie signalmässig und/oder impedanzmässig angepasst an die Heiz- und/oder Kühlelemente 64 weiterleiten. An der übergeordneten Elektronik-Einheit 65 werden die Eingangssignale von den Sensoren 62 beispielsweise in ihrer Gesamtheit mit einer, wie bei S schematisch dargestellt, an die Einheit 65 eingegebenen SOLL-Temperaturverteilung entlang des Werkstückträgertisches 60 verglichen, und im Sinne einer Regelung wird an der Einheit 65 der SOLL/IST-Wertvergleich vorgenommen und, mit entsprechender Charakteristik, die Übertragungsglieder $Z_1$ bzw. $Z_2$ gebildet.

Gemäss Fig. 5, woran dieselben Teile mit denselben Bezugszeichen wie in Fig. 4 bezeichnet sind, bildet die Elektronik-Einheit 63 direkt SOLL/IST-Wert-Differenz und die Regelglieder entsprechend $Z_1$ und $Z_2$. Hier wird die erwünschte Temperaturverteilung $T_{soll}$ direkt der erfindungsgemäss potentialgelegten Elektronik-Einheit 63 zugespiesen bzw. an ihr abgespeichert.

Der Fachmann erkennt ohne weiteres, dass, analog, die Temperatur bzw. Temperaturverteilung oder allgemein der Zustand an weiteren Teilen der Anlage erfasst und ggf. geregelt werden kann, so insbesondere an einer Targetanordnung.

In Fig. 6 ist eine weitere bevorzugte erfindungsgemässe Anlage schematisch dargestellt. Beispielsweise zur Durchführung eines CVD- oder PECVD-Oberflächenbehandlungs-Verfahrens ist ein Gassensor 70 im Bereich eines auf einem Werkstückträgertisch 72 abgelegten Werkstückes 74 angeordnet. Die auswertende Elektronik-Einheit 73 ist, wie mit der galvanischen Verbindung 76 schematisch dargestellt, gemeinsam mit dem Sensor 70 auf das Potential des Tisches 72, hier als der Teil 9 wirkend, gelegt.

Wie bereits der Werkstückträgertisch 60 gemäss den Fig. 4 und 5, kann auch hier der Werkstückträgertisch 72 je nach durchgeführtem Behandlungsprozess auf ein erwünschtes Bias-Potential gelegt werden, sei dies ein DC- und/oder ein AC-Potential, wie dies in Fig. 6 schematisch mit der Quelle 80 und den gestrichelten Verbindungen dargestellt ist, mit Bezug auf das als Bezugspotential $\phi_0$ an die Wandung 78 der Vakuumkammer angelegte Massepotential.

Über eine galvanische Trenneinheit 82 stellt die Elektronikeinheit 73 eine Ventilanordnung 84, welche den Gasfluss G von einem Gastank 88 und aus einer Gaseindüsung 86 stellt, vorzugsweise regelt.

Das erfindungsgemässe Vorgehen wird insbesondere bevorzugt bei Vakuumbehandlungsanlagen eingesetzt, bei denen Plasmaentladungen realisiert werden, wie insbesondere bei reaktiven oder nichtreaktiven Sputterbeschichtungs- oder Sputterätzbehandlungsanlagen oder bei plasmaunterstützten CVD-Behandlungsanlagen, aber ggf. auch bei Arc-Verdampfungsanlagen oder Elektronenstrahlverdampfungsanlagen, generell bei Anlagen, an denen dort genaue Messungen bzw. genaue Stelleingriffe gefordert sind, wo im Betrieb und bezüglich Anlagenbezugspotential hohe Spannungen vorherrschen oder auftreten können.

Damit ergibt sich durch das erfindungsgemässe Vorgehen die Möglichkeit, kleine Signale zu erfassen mit einer Genauigkeit, die nur durch die Messelektronik in der Einheit 13' begrenzt ist. Eine Anlage, welche für die gleiche Mess- bzw. Stellbedürfnisse ausgelegt ist, gemäss vorbekanntem Vorgehen nach Fig. 1, ist in der Grössenordnung eines Faktors 3 bis 4 kostenaufwendiger als bei Befolgung der erfindungsgemässen Technik, wie anhand der Figuren 2 bzw. 3 erläutert.

**Patentansprüche**

1. Vakuumbehandlungsanlage mit mindestens einer Vakuumbehandlungskammer (1), wobei ein Teil der Anlage mit einem elektrischen Anlage-Bezugspotential ($\Phi_o$) verbunden ist, in der Vakuumbehandlungskammer (1) ein weiterer Teil (9) vorgesehen ist, der dazu angepaßt ist, auf ein vom Anlagebezugspotential ($\Phi_o$) um mindestens 12V abweichendes Potential ($\Phi_9$) gelegt zu werden und an diesem weiteren Teil (9) mindestens ein Sensor und/oder mindestens ein Stellglied (11; 36, 34; 62, 64; 70) angeordnet ist, weiter mit einer Elektronik-Einheit (13, 63; 73), die ein- und/oder ausgangsseitig mit dem Sensor und/oder Stellglied verbunden ist, wobei die Elektronik-Einheit (13; 63; 73) dazu angepaßt ist, auf einem weiteren Bezugspotential betrieben zu werden, das das Potential ($\Phi_9$) des weiteren Teils (9) ist, und die Elektronik-Einheit (13; 63; 73) innerhalb der Vakuumbehandlungskammer eingebaut ist.

2. Vakuumbehandlungsanlage nach Anspruch 1, bei der in der Vakuumbehandlungskammer (1) eine Entladungsstrecke vorgesehen ist, dabei vorzugsweise der weitere Teil

   • eine der Entladungselektroden ist oder
   • ein weiterer der Entladung ausgesetzter Teil, der dazu angepaßt ist, auf Schwebepotential oder auf bestimmtem Potenzial betrieben zu werden.

3. Anlage nach Anspruch 1 oder 2, **dadurch gekennzeichnet, dass** mindestens ein Sensor und mindestens ein Stellglied vorhanden sind und der Sensor ein Temperatursensor ist, das Stellglied eine Heiz- und/oder Kühleinrichtung, vorzugsweise eine Mehrzonen-Heizung bzw. -Kühlung.

4. Anlage nach einem der Ansprüche 1 bis 3, **dadurch gekennzeichnet, dass** der weitere Teil eine Werkstückaufnahme ist und der mindestens eine oder ein weiterer Sensor für die Überprüfung des Vorhandenseins eines Werkstückes, wobei vorzugsweise am Teil elektrostatisch oder durch Unterdruck auf die Werkstücke wirkende Halteorgane vorgesehen sind und der mindestens eine oder der weitere solche Sensor zur Überprüfung der Werkstückhalterung vorgesehen ist und vorzugsweise über die Elektronik-Einheit auf die Halterung rückwirkt.

5. Anlage nach einem der Ansprüche 1 bis 4, **dadurch gekennzeichnet, dass** der weitere Teil unmittelbar im Bereich eines Gaseinlasses oder eines Werkstückes vorgesehen ist, der mindestens eine oder ein weiterer Sensor ein Gasflussfühler ist, und die Elektronik-Einheit ausgangsseitig mit einer Stell-Anordnung in einer Gaszuführung zum Gaseinlass wirkverbunden ist.

6. Anlage nach einem der Ansprüche 1 bis 3, oder 5 wenn auf Ausprüche 1-3 rückbezogen, **dadurch gekennzeichnet, dass** der weitere Teil eine Targetanordnung ist, der mindestens eine Sensor oder ein weiterer Sensor die Temperatur des Targets und/oder seinen Zustand erfasst.

7. Anlage nach einem der Ansprüche 1 bis 6, **dadurch gekennzeichnet, dass** die Elektronik-Einheit eine digitale, vorzugsweise programmierbare Einheit umfasst, vorzugsweise mindestens einen programmierbaren digitalen Logikbaustein und/oder eine digitale Rechen-Einheit, vorzugsweise einen Mikroprozessor und/oder einen Mikrocomputer, mit Speichermitteln für die Betriebsprogramme.

8. Anlage nach einem der Ansprüche 1 bis 7, **dadurch gekennzeichnet , dass** sie Mittel umfaßt, den weiteren Teil (9) bezüglich des Anlagen-Bezugspotentials ($\Phi_o$) auf AC-Potential und/oder auf DC-Potential zu legen, wobei AC den Hf- und Mikrowellenbereich mitumfassen kann, oder daß der weitere Tei (9) elektrisch isoliert angeordnet ist.

9. Anlage nach einem der Ansprüche 1 bis 5; oder 7, 8 wenn auf Ansprüche 1-5 rückbezogen **dadurch gekennzeichnet, dass** der weitere Teil (9) ein Substratträger ist.

10. Anlage nach einem der Ansprüche 1 bis 9, mit Mitteln, den weiteren Teil (9) bezüglich Anlagen-Bezugspotential

($\Phi_o$) auf HF-Potenzial ($\Phi_9$) zulegen, in einem Frequenzbereich:

zwischen 100 kHz und 100 MHz,
vorzugsweise
zwischen 5 MHz und 50 MHz,

vorzugsweise auf ca. 13,56 MHz,
und, weiter vorzugsweise, mit Mitteln, den weiteren Teil (9) bezüglich Anlagen-Bezugspotential ($\Phi_o$) auf eine Potentialdifferenz bzw. Spannung mit einem Spitzenwert $V_{pp}$ zu legen, für den gilt:

$$25\ V \leq V_{pp} \leq 2'000\ V,$$

vorzugsweise

$$50\ V \leq V_{pp} \leq 500\ V.$$

**11.** Anlage nach einem der Ansprüche 1 bis 9, mit Mitteln, das Potential $\Phi_9$ des weiteren Teils so zu legen, dass es um

$$12\ V \leq |\Phi_0 - \Phi_9| \leq 2000\ V$$

vom Bezugspotential $\Phi_0$ der Anlage abweicht, vorzugsweise um

$$25\ V \leq |\Phi_0 - \Phi_9| \leq 500\ V.$$

**12.** Anlage nach einem der Ansprüche 1 bis 11, **dadurch gekennzeichnet, dass** die Elektronikeinheit (13, 13') mechanisch am weiteren Teil (9) angeordnet ist.

**13.** Anlage nach einem der Ansprüche 1 bis 12, **dadurch gekennzeichnet, dass** die Elektronikeinheit (13, 13') von einem Faradaykäfig (48), vorzugsweise auf dem Bezugspotential der Anlage ($\Phi_0$) liegend, umschlossen ist.

**14.** Anlage nach einem der Ansprüche 1 bis 13, mit Mitteln, den weitere Teil auf Hf-Potential zu legen, wobei die vom Kammeräusseren an die Elektronik-Einheit (13, 13') in der Vakuumbehandlungskammer (1) geführten Leitungen und/oder von dieser nach aussen geführten Leitungen mindestens teilweise über eine Hf-Filteranordnung (52) geführt sind, die vorzugsweise von einem auf dem Anlagen-Bezugspotential ($\Phi_0$) liegenden Faradaykäfig (54) umschlossen ist.

**15.** Anlage nach einem der Ansprüche 1 bis 14, **dadurch gekennzeichnet, dass** die Elektronik-Einheit (13, 13') mit einer übergeordneten Stell- und/oder Überwachungseinheit, vorzugsweise mit einem Host-Rechner, verbunden ist, und dass diese Verbindung mindestens zum Teil über eine galvanische Trenneinheit (30, 50) erfolgt.

**16.** Anlage nach Anspruch 14, oder 15 wenn auf 14 rückbezogen, **dadurch gekennzeichnet, dass** mindestens ein Teil der Leitungen über galvanische Trennstellen geführt sind.

**Claims**

**1.** Vacuum treatment plant with at least one vacuum treatment chamber (1), wherein a part of the plant is connected to an electrical plant reference potential ($\phi_0$), in the vacuum treatment chamber (1) is provided a further part (9) which is adapted to be put to a potential ($\phi_9$) deviating from the plant reference potential ($\phi_0$) by at least 12V, and at this further part (9) is arranged at least one sensor and/or at least one actuator (11; 36, 34; 62, 64; 70), furthermore with an electronics unit (13; 63; 73) which is on the input and/or output side connected to the sensor and/or actuator, wherein the electronics unit (13; 63; 73) is adapted to be operated at a further reference potential which is the potential ($\phi_9$) of the further part (9), and the electronics unit (13; 63; 73) is installed inside the vacuum treatment chamber.

2. Vacuum treatment plant according to claim 1, in which a discharge path is provided in the vacuum treatment chamber (1), wherein preferably the further part is

   • one of the discharge electrodes or
   • a further part exposed to the discharge which is adapted to be operated on floating potential or a specific potential.

3. Plant according to claim 1 or 2, **characterised in that** at least one sensor and at least one actuator are present and the sensor is a temperature sensor, the actuator a heating and/or cooling device, preferably a multizone heating or cooling device.

4. Plant according to any one of claims 1 to 3, **characterised in that** the further part is a workpiece holder and the at least one or a further sensor is provided for checking the presence of a workpiece, wherein preferably at the part retaining elements are provided acting on the workpiece electrostatically or by reduced pressure, and the at least one or the further such sensor is provided to check the workpiece retention and preferably reacts on the retention via the electronics unit.

5. Plant according to any one of claims 1 to 4, **characterised in that** the further part is provided directly in the area of a gas inlet or of a workpiece, the at least one or a further sensor is a gas flow sensor, and the electronics unit is operationally connected on the output side to an actuator arrangement in a gas supply to the gas inlet.

6. Plant according to any one of claims 1 to 3, or 5 when referring back to claims 1 - 3, **characterised in that** the further part is a target arrangement, the at least one sensor or a further sensor detecting the temperature of the target and/or its state.

7. Plant according to any one of claims 1 to 6, **characterised in that** the electronic unit comprises a digital, preferably programmable unit, preferably at least one programmable digital logic module and/or a digital computing unit, preferably a microprocessor and/or a microcomputer, with memory means for the operating programs.

8. Plant according to any one of claims 1 to 7, **characterised in that** it comprises means for putting the further part (9) in reference to the plant reference potential ($\phi_0$) to AC potential and/or DC potential, wherein AC can comprise the Hf and microwave range, or that the further part (9) is arranged electrically isolated.

9. Plant according to any one of claims 1 to 5; or 7, 8 when referring back to claims 1 - 5, **characterised in that** the further part (9) is a substrate carrier.

10. Plant according to any one of claims 1 to 9, with means for putting the further part (9) in reference to plant reference potential ($\phi_0$) to HF potential ($\phi_9$) in a frequency range:

    between 100 kHz and 100 MHz
    preferably
    between 5 MHz and 50 MHz,
    preferably to approximately 13.56 MHz,

    and further preferably with means for putting the further part (9) in reference to plant reference potential ($\phi_0$) to a potential difference or voltage with a peak value $V_{pp}$ for which applies:

$$25 \text{ V} \leq V_{pp} \leq 2000 \text{ V}$$

    preferably

$$50 \text{ V} \leq \text{V}_{pp} \leq 500 \text{ V}.$$

**11.** Plant according to any one of claims 1 to 9, with means for putting the potential ($\phi_9$) of the further part such that it deviates from the plant reference potential ($\phi_0$) by

$$12 \text{ V} \leq |\phi_0 - \phi_9| \leq 2000 \text{ V}$$

preferably by

$$25 \text{ V} \leq |\phi_0 - \phi_9| \leq 500 \text{ V}.$$

**12.** Plant according to any one of claims 1 to 11, **characterised in that** the electronics unit (13, 13') is mechanically arranged at the further part (9).

**13.** Plant according to any one of claims 1 to 12, **characterised in that** the electronics unit (13, 13') is surrounded by a Faraday cage (48), which preferably is put to the plant reference potential ($\phi_0$).

**14.** Plant according to any one of claims 1 to 13, with means for putting the further part to Hf potential, wherein the lines guided from the chamber exterior to the electronics unit (13, 13') in the vacuum treatment chamber (1) and/or the lines guided outward from this are guided at least partly via an Hf filter arrangement (52) which preferably is surrounded by a Faraday cage (54) put to the plant reference potential ($\phi_0$).

**15.** Plant according to any one of claims 1 to 14, **characterised in that** the electronics unit (13, 13') is connected to a superior actuator and/or monitoring unit, preferably with a host computer, and that this connection takes place at least partly via a galvanic separating unit (30, 50).

**16.** Plant according to claim 14, or 15 when referring back to claim 14, **characterised in that** at least in part the lines are guided via galvanic separating points.

**Revendications**

**1.** Installation de traitement sous vide avec au moins une chambre de traitement sous vide (1), une partie de l'installation étant reliée à un potentiel électrique de référence d'installation ($\phi_0$), une autre partie (9) étant prévue dans la chambre de traitement sous vide (1), laquelle autre partie est adaptée pour être mise à un potentiel ($\phi_9$) différent d'au moins 12 V du potentiel de référence d'installation ($\phi_0$), et au moins un capteur et/ou au moins un élément de réglage (11 ; 36, 34 ; 62, 64 ; 70) étant disposés sur cette autre partie (9), en outre avec une unité électronique (13 ; 63 ; 73) qui est reliée côté entrée et/ou côté sortie au capteur et/ou à l'élément de réglage, l'unité électronique (13 ; 63 ; 73) étant adaptée pour fonctionner à un autre potentiel de référence qui est le potentiel ($\phi_9$) de l'autre partie (9), et l'unité électronique (13 ; 63 ; 73) étant montée à l'intérieur de la chambre de traitement sous vide.

**2.** Installation de traitement sous vide selon la revendication 1, dans laquelle il est prévu une voie de décharge dans la chambre de traitement sous vide (1), l'autre partie, de préférence,

- étant l'une des électrodes de décharge ou
- une autre partie qui est soumise à la décharge et qui est adaptée pour fonctionner à un potentiel flottant ou à un potentiel déterminé.

**3.** Installation selon la revendication 1 ou 2, **caractérisée par le fait qu'**au moins un capteur et au moins un élément de réglage sont prévus et que le capteur est un capteur de température et l'élément de réglage est un dispositif de chauffage et/ou de refroidissement, de préférence pour un chauffage ou un refroidissement à zones multiples.

**4.** Installation selon l'une des revendications 1 à 3, **caractérisée par le fait que** l'autre partie est un logement de pièce et le capteur ou un autre capteur est prévu pour la vérification de la présence d'une pièce, de préférence sur la partie des organes de retenue agissant de manière électrostatique ou par vide partiel étant alors prévus et le capteur ou l'autre capteur étant alors prévu pour la vérification de la fixation de pièce et ayant une rétroaction sur la fixation de préférence par l'intermédiaire de l'unité électronique.

**5.** Installation selon l'une des revendications 1 à 4, **caractérisée par le fait que** l'autre partie est prévue directement dans la zone d'une admission de gaz ou d'une pièce, que le capteur ou un autre capteur est un capteur de flux gazeux, et que l'unité électronique est en liaison fonctionnelle, côté sortie, avec un dispositif de réglage dans une arrivée de gaz à l'admission de gaz.

**6.** Installation selon l'une des revendications 1 à 3, ou 5 dans le cas où elle est considérée comme dépendante des revendications 1 à 3, **caractérisée par le fait que** l'autre partie est un dispositif cible et que le capteur ou un autre capteur détecte la température de la cible et/ou son état.

**7.** Installation selon l'une des revendications 1 à 6, **caractérisée par le fait que** l'unité électronique comprend une unité numérique, de préférence programmable, de préférence au moins un composant logique numérique programmable et/ou une unité de calcul numérique, de préférence un microprocesseur et/ou un micro-ordinateur, avec des moyens de mémorisation pour les programmes d'exploitation.

**8.** Installation selon l'une des revendications 1 à 7, **caractérisée par le fait qu'**elle comprend des moyens pour mettre l'autre partie (9), par rapport au potentiel de référence d'installation ($\phi_0$), à un potentiel AC et/ou à un potentiel DC, AC pouvant comprendre la plage HF et micro-ondes, ou que l'autre partie (9) est disposée électriquement isolée.

**9.** Installation selon l'une des revendications 1 à 5 ; ou 7, 8 dans le cas où elles sont considérées comme dépendantes des revendications 1 à 5, **caractérisée par le fait que** l'autre partie (9) est un support de substrat.

**10.** Installation selon l'une des revendications 1 à 9, avec des moyens pour mettre l'autre partie (9), par rapport au potentiel de référence d'installation ($\phi_0$), à un potentiel HF ($\phi_9$) dans une plage de fréquences :

entre 100 kHz et 100 MHz,
de préférence
entre 5 MHz et 50 MHz,
de préférence à 13,56 MHz environ,

et encore de préférence avec des moyens pour mettre l'autre partie (9), par rapport au potentiel de référence d'installation ($\phi_0$), à une différence de potentiel ou tension ayant une valeur de pointe Vpp pour laquelle on a :

$$25 \text{ V} \leq V_{pp} \leq 2\,000 \text{ V,}$$

de préférence

$$50 \text{ V} \leq V_{pp} \leq 500 \text{ V.}$$

**11.** Installation selon l'une des revendications 1 à 9, avec des moyens pour mettre le potentiel ($\phi_9$) de l'autre partie de telle sorte qu'il est différent du potentiel de référence $\phi_0$ de l'installation de

$$12 \text{ V} \leq |\phi_0 - \phi_9| \leq 2\,000 \text{ V,}$$

de préférence

$$25 \text{ V} \leq |\phi_0 - \phi_9| \leq 500 \text{ V.}$$

**12.** Installation selon l'une des revendications 1 à 11, **caractérisée par le fait que** l'unité électronique (13, 13') est disposée mécaniquement sur l'autre partie (9).

13. Installation selon l'une des revendications 1 à 12, **caractérisée par le fait que** l'unité électronique (13, 13') est entourée par une cage de Faraday (48) se trouvant de préférence au potentiel de référence ($\phi_0$) de l'installation.

14. Installation selon l'une des revendications 1 à 13, avec des moyens pour mettre l'autre partie à un potentiel HF, les lignes conduisant de l'extérieur de la chambre à l'unité électronique (13, 13') dans la chambre de traitement sous vide (1) et/ou les lignes conduisant de cette dernière à l'extérieur passant au moins en partie par un dispositif de filtrage HF (52) qui est entouré de préférence par une cage de Faraday (54) se trouvant au potentiel de référence ($\phi_0$) de l'installation.

15. Installation selon l'une des revendications 1 à 14, **caractérisée par le fait que** l'unité électronique (13, 13') est reliée à une unité de réglage et/ou de surveillance de rang supérieur, de préférence à un ordinateur principal, et que cette liaison s'effectue au moins en partie par une unité d'isolation électrique (30, 50).

16. Installation selon la revendication 14, ou 15 dans le cas où elle est considérée comme dépendante de la revendication 14, **caractérisée par le fait qu'**au moins une partie des lignes passe par des points de coupure électrique.

FIG.1

FIG.2

FIG.3

FIG. 4

FIG.5

FIG.6

**EP 1 042 782 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5270637 A
- US 5144231 A

- US 5365147 A